# FASCICULE DE BREVET EUROPEEN

(11) **EP 0 441 450 B1**
(45) Date de publication et mention de la délivrance du brevet: **24.07.1996**
(21) Numéro de dépôt: 91200246.6
(22) Date de dépôt: 06.02.1991
(51) Int. Cl.: H01L 21/28, H01L 21/331

(54) **Procédé de réalisation par autoalignement, d'un dispositif semiconducteur intégré, comprenant au moins la formation d'un premier contact d'électrode encapsulé et muni d'espaceurs et d'un second contact d'électrode autoaligné sur celui-ci**
Verfahren zur Herstellung einer integrierten Halbleitervorrichtung beinhaltend die Ausbildung einer ersten Kontaktelektrode, welche gekapselt und mit Distanzstück versehen ist und einer zweiten Kontaktelektrode, die automatisch zur ersten justiert ist
Process for manufacturing an integrated semiconductor device comprising the formation of a first contact electrode, encapsulated and provided with spacers, and a second contact electrode auto-aligned to the first

(30) Priorité: 09.02.1990 FR 9001531
(43) Date de publication de la demande: 14.08.1991
(73) Titulaire: LABORATOIRES D'ELECTRONIQUE PHILIPS S.A.S., 94450 Limeil-Brévannes (FR); Philips Electronics N.V., 5621 BA Eindhoven (NL)
(72) Inventeur: Selle, Daniel, F-75008 Paris (FR); Carisetti, Dominique, F-75008 Paris (FR)
(74) Mandataire: Landousy, Christian

(56) Documents cités:
- EP-A- 0 312 965

## Description

L'invention concerne un procédé de réalisation d'un dispositif semiconductuer du type transistor bipolaire à hétérojonction (HBT) comprenant, pour former des contacts d'électrodes d'émetteur et de base autoalignés, des étapes de :
aₒ) empilement sur un substrat d'au moins trois couches semiconductrices, de types de conductivité alternés, pour former respectivement à partir dudit substrat les couches de collecteur, base et émetteur du transistor ;
bₒ) dépôt en surface de la couche supérieure d'émetteur, désignée par première couche semiconductrice, d'une couche de photorésist, et formation dans ladite couche de photorésist d'une ouverture (Bₒ) délimitant la région d'un premier contact d'électrode.

Il est déjà connu du brevet EP 0 312 965, un procédé de réalisation d'un transistor HBT qui comprend la réalisation :
a) d'un empilement de couches semiconductrices appropriées à réaliser un transistor HBT,
b₁) d'une couche de photorésist ayant des ouvertures pour délimiter des régions de base,
b₂) d'une gravure de la couche supérieure d'émetteur jusqu'à atteindre la couche de base, à travers les ouvertures dans la photorésist, cette gravure produisant une légère sous-gravure par rapport au masque constitué par ladite couche de photorésist qui couvre la région d'émetteur,
c) d'un dépôt d'une première couche métallique pour former les contacts de base du transistor, cette couche étant d'un matériau apte à supporter des températures élevées, et étant formée en surface de la couche de base denudée par la gravure de l'étape précédente,
d) d'un dépôt d'une première couche diélectrique pour protéger les contacts de base,
e) d'un lift-off permettant de garder la protection sur les contacts de base et de dénuder le contact d'émetteur précédemment protégé par la photorésist,
f) d'espaceurs autour des contacts de base pour délimiter le futur contact métallique d'émetteur,
h₁) d'un dépôt d'une seconde couche métallique pour former le plot de contact d'émetteur limité à sa base par les espaceurs des plots de base, et à sa partie supérieure par une ouverture dans une seconde couche de photorésist, de sorte que le plot d'émetteur s'étend partiellement au-dessus des plots de base avec isolation par l'encapsulant de ces plots de base,
h₂) d'un dépôt d'une seconde couche diélectrique sur la couche métallique d'émetteur,
i) du lift-off des couches autour des plots de contact de base et d'émetteur, l'émetteur restant encapsulé au moyen de la seconde couche diélectrique.

Il est également connu de la demande de brevet européen EP 0 322 960, un procédé d'autoalignement pour réaliser un transistor bipolaire à hétérojonction planaire. Dans cette demande, le procédé comporte d'abord la réalisation des deux contacts de base du transistor sur la surface supérieure du dispositif. Ces contacts sont ensuite encapsulés et muni d'espaceurs. La distance entre les bords externes des espaceurs définit la dimension du contact d'émetteur qui est réalisé dans l'ouverture formée par les espaceurs, entre les contacts de base. La dimension latérale des espaceurs définit aussi la distance qui sépare chacun des contacts de base, du contact d'émetteur.

Mais, selon ce dernier procédé connu, les couches d'émetteur de base et de collecteur forment une structure de couches semiconductrices superposées, alors que tous les contacts d'électrodes sont réalisés sur la surface supérieure du dispositif. Ce procédé inclut donc des étapes de réalisation d'implantations localisées d'espèces propres à relier les contacts d'électrode avec les couches d'électrodes respectives.

Or, les implantations localisées s'avèrent à ce jour coûteuses parce que difficile à mettre en oeuvre avec précision ; et il est préféré, pour la réalisation en grand nombre de circuits intégrés, de ne pas avoir recours à ces techniques. Dans ces conditions, le problème se pose de réaliser les contacts directement sur les couches appropriées, par un procédé aussi simple que possible, tout en réalisant les électrodes aussi rapprochées les unes des autres que possible, de manière à obtenir des dispositifs performants et occupant une surface aussi faible que possible du circuit intégré. En effet, lorsque les contacts d'émetteur et de base sont éloignés les uns des autres, il apparaît, lors du fonctionnement, des éléments parasites qui diminuent les performances du transistor, comme il est connu de l'homme du métier.

Un objet de la présente invention est donc de proposer un procédé d'autoalignement -mettant en oeuvre des étapes de réalisation d'un premier contact d'électrode encapsulé et muni d'espaceurs, et l'autoalignement d'un ou plusieurs autres contacts sur ce premier contact- qui peut être appliqué à la réalisation de dispositifs non planaires.

Un autre objet de l'invention est de proposer un procédé de réalisation d'un transistor bipolaire à hétérojonction, mettant en oeuvre ce procédé d'autoalignement, pour obtenir un dispositif plus performant, plus compact, plus simple à réaliser, donc plus intéressant et plus prometteur sur le plan industriel.

Ces buts sont atteint au moyen d'un procédé tel que décrit dans le préambule de la revendication 1, ce procédé étant caractérisé en ce que :
ledit premier contact d'électrode est le contact d'émetteur du transistor,
en ce que, dans l'étape bₒ) l'ouverture (Bₒ) est réalisée dans la couche de photorésist par une méthode désignée par méthode d'inversion d'image, selon laquelle l'ouverture formée a des flancs renversés, i.e ayant une convexité dont la partie renflée est tournée vers ladite ouverture (Bₒ),
et en ce que le procédé se poursuit par les étapes de :
cₒ) dépôt, en surface de ladite couche de photorésist (8) et directement en surface de ladite première couche semiconductrice d'émetteur d'une première couche métallique pour former ledit premier contact d'émetteur (E) délimité par la partie supérieure de ladite ouverture (Bₒ), ledit premier contact d'émetteur (E) ayant une hauteur inférieure à l'épaisseur de la couche de photorésist et ayant des flancs (F₂) qui, dans leur partie supérieure arrivent à une petite distance (d) non nulle des flancs renversés (F₁) de l'ouverture (Bₒ), et qui dans leur partie inférieure laissent une lumière (A) avec la partie inférieure desdits flancs renversés (F₁),
dₒ) dépôt d'une couche diélectrique désignée par première couche diélectrique, d'une épaisseur supérieure à la dite distance d'affleurement (d), couvrant la première couche métallique sans emplir la lumière (A),
eₒ) arrachage (lift-off) de la couche de photorésist, entraînant ladite première couche métallique et ladite première couche diélectrique autour dudit premier contact d'émetteur, lequel reste couvert d'une partie de la première couche diélectrique désignée par encapsulant,
fₒ) dépôt d'une couche diélectrique, désignée par seconde couche diélectrique, d'une épaisseur uniforme de valeur spécifique (h₁), puis gravure de cette seconde couche diélectrique uniformément d'une hauteur égale à la valeur spécifique (h₁), pour former autour du premier contact d'émetteur des espaceurs de dimension latérale égale à ladite valeur spécifique (h₁),
gₒ) gravure de la première couche semiconductrice d'émetteur, autour du premier contact d'émetteur (E) muni de l'encapsulant et des espaceurs, ce contact ainsi équipé constituant un premier masque pour ladite gravure, jusqu'à atteindre la couche semicondrice sous-jacente de base, désignée par seconde couche semiconductrice, ladite gravure incluant une sous-gravure sous lesdits espaceurs,
hₒ) dépôt d'une seconde couche métallique pour former ledit second contact de base (B), délimité d'une part par ledit premier masque formé du premier contact d'émetteur (E) muni de l'encapsulant et des espaceurs, et d'autre part par les bords de l'ouverture d'un second masque ;
iₒ) enlèvement de l'encapsulant, des espaceurs et du second masque entraînant l'arrachage par lift-off de la portion de couche métallique déposée sur ledit encapsulant, sur lesdits espaceurs et sur ledit second masque lors de l'étape précédente.

Ce procédé présente, entre autres les avantages suivants :
- il permet d'obtenir dans un dispositif semiconducteur, undit premier contact d'électrode qui présente des dimensions transversales très faibles, ceci est dû à l'utilisation de la méthode d'inversion d'image ;
- il permet d'obtenir que, lors de la formation de l'encapsulant de ce contact, encapsulant avantageux pour la protection du contact durant les étapes ultérieures du procédé, il n'apparaisse aucun bourrelet ou irrégularité autour de l'encapsulant : ceci est dû à la formation de la lumière autour de l'embase du contact, lumière grâce à laquelle, lors du "lift-off" des couches diélectriques et métalliques, la seconde couche diélectrique casse facilement au niveau de ladite petite distance séparant les bords du contact des flancs de l'ouverture, laissant un encapsulant de forme pratiquement parfaite, ce qui permet ensuite de réaliser des espaceurs avec une grande précision ;
- il permet d'obtenir ce résultat d'une manière rapide, sûre, performante et répétitive, car le procédé d'inversion d'image est bien maîtrisable et les autres étapes sont simples pour un homme du métier ;
- il est applicable entre autres, à la réalisation d'un transistor non planaire très performant, du fait qu'il permet de réaliser en premier lieu le contact d'électrode dont les dimensions sont les plus critiques, premier contact d'électrode sur lequel vont être autoalignés lesdits seconds contacts d'électrodes, dont la distance avec le premier contact est en fait aussi un élément critique ; ce procédé permet de lever toutes les difficultés dues à la réalisation de ces dimensions ou distances critiques.

Dans les étapes déjà citées du procédé et dans des étapes ultérieures du procédé, décrites plus loin, un autre avantage réside dans le fait que durant toute la réalisation du dispositif intégré les éléments sensibles aux gravures, comme les contacts d'électrodes, ou les flancs de couches d'électrodes, sont toujours protégés.

Un autre avantage réside encore dans le fait qu'à l'issue du procédé, non seulement les électrodes sont séparées par des distances très précises qui augmentent les performances, mais encore elles ne restent pas munies de couches de séparation en matériau diélectrique, telles qu'il en existe dans certains dispositifs connus de l'homme du métier pour éviter les courts-circuits, et qui créent en revanche des éléments parasites.

L'invention sera mieux comprise au moyen de la description suivante illustrée par les figures annexées dont :
- la figure 1a qui représente un transistor bipolaire à hétérojonction, en coupe, réalisé en utilisant le procédé selon l'invention ;
- la figure 1b qui représente ce même transistor vu du dessus, dans un exemple de réalisation, l'axe I-I étant celui selon lequel la coupe de la figure 1a précédente a été réalisée ;
- les figures 2a à 2j qui illustrent les étapes pour réaliser ce transistor au moyen du procédé selon l'invention ;
- les figures 3a et 3b qui illustrent les étapes de réalisation d'espaceurs autour d'un contact encapsulé.
- les figures 4a à 4c qui illustrent le procédé de réalisation d'une ouverture à flancs renversés, dans une couche de photorésist par une méthode d'inversion d'image conforme à l'invention ;
- la figure 4d qui montre la formation de la petite distance d et de la lumière A pour obtenir un premier contact conforme à l'invention.

L'invention propose un procédé de réalisation d'un dispositif semiconducteur intégré qui comprend au moins la réalisation sur des couches semiconductrices de deux contacts d'électrode. Pour éviter la réalisation d'implantations localisées, on réalisera de préférence le dispositif sous la forme d'une structure de couches superposées sur lesquelles les contacts d'électrode seront réalisés directement.

L'invention trouvera alors une application particulièrement intéressante dans la réalisation de transistors bipolaires à hétérojonction, mais il n'est pas exclu d'appliquer l'invention à des transistors planaires par exemple. On décrira ci-après l'invention dans une de ses formes de réalisation les plus complexes, c'est-à-dire la réalisation d'un transistor bipolaire à hétérojonction non planaire.

Tel que représenté sur la figure 1a, dans un exemple de mise en oeuvre, un transistor bipolaire à hétérojonction réalisé au moyen de l'invention comprend d'abord sur un substrat lisse, par exemple semi-isolant, une couche 2 d'un premier type de conductivité ou couche collecteur ; une couche 3 d'un second type de conductivité ou couche de base ; et une couche 5a du premier type de conductivité ou couche d'émetteur.

Dans une forme de réalisation particulière favorable le transistor sera réalisé en un matériau du groupe III-V, par exemple en arséniure de gallium (GaAs). Dans ce cas le substrat sera semi-isolant en arséniure de gallium GaAs, la couche de collecteur 2 pourra être formée de deux sous-couches 2a et 2b, la couche 2a étant de type de conductivité N⁺ et la couche 2b de type de conductivité N. La couche de base 3 sera de type de conductivité P⁺ en arséniure de gallium, et la couche d'émetteur sera en arséniure de gallium et d'aluminium (GaAlAs) de type de conductivité N formant une hétérojonction avec la couche de base. En surface de la couche 5a d'émetteur, pour permettre la prise des contacts, on formera de préférence une couche épitaxiale 5b d'arséniure de gallium de type de conductivité N⁺.

Dans cet exemple de réalisation, où le transistor est en arséniure de gallium, le contact métallique d'émetteur est réalisé directement en surface de la couche 5b, une gravure est pratiquée autour du contact métallique d'émetteur E 9 de manière à dégager la couche de base 3 pour pouvoir réaliser des contacts de base B 16. Enfin une gravure est pratiquée autour des contacts de base jusqu'à la couche de collecteur 2a sur laquelle sont déposés les contacts de collecteur C 19.

Dans cette réalisation, le contact de base peut être réalisé au moyen de métaux tels Au-Mn ou Au-Be. Les contacts d'émetteur et de collecteur au moyen de métaux tels que AuGe/Ni/Ti/Au. On décrit ci-après un procédé pour réaliser l'auto-alignement des divers contacts d'électrode les uns sur les autres. Selon ce procédé, on pourra particulièrement obtenir que le contact de base B soit très proche du plot d'émetteur E sans pour autant risquer de court-circuits avec le contact d'émetteur E. On pourra également obtenir que le contact d'émetteur soit de dimension transversale très faible.

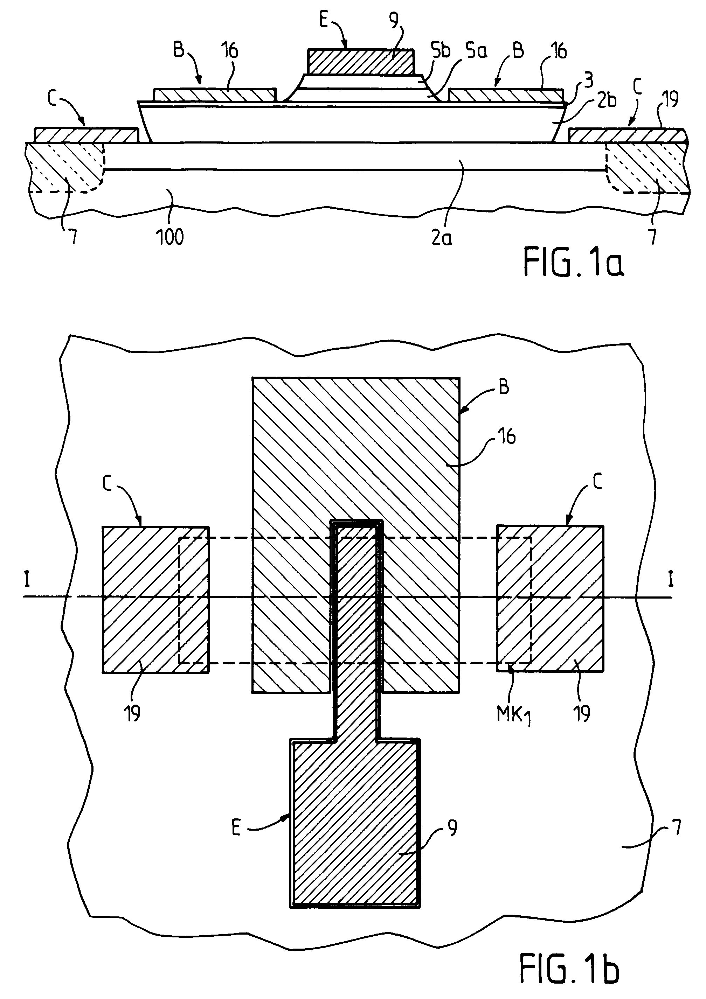

La figure 1b représente ce transistor bipolaire à hétérojonction vu du dessus, la figure 1a décrite précédemment étant une coupe selon l'axe I-I de cette figure 1b.

Tel que représenté vu du dessus sur la figure 1b, dans cet exemple de réalisation, le transistor a une structure interdigitée à deux doigts de base B et un doigt d'émetteur E. Il montre aussi deux plots de contact de collecteur C.

Dans le procédé décrit ci-après les doigts de base sont auto-alignés sur le doigt d'émetteur. Et les plots de collecteur sont ensuite alignés sur les doigts de base.

Ce procédé permet d'obtenir les dimensions transverses extrêmement faibles, précises et répétitives et donc des transistors de très faibles dimensions dont les performances sont améliorées. Ceci fait que la densité d'intégration peut être augmentée et que les performances des circuits sont aussi améliorées.

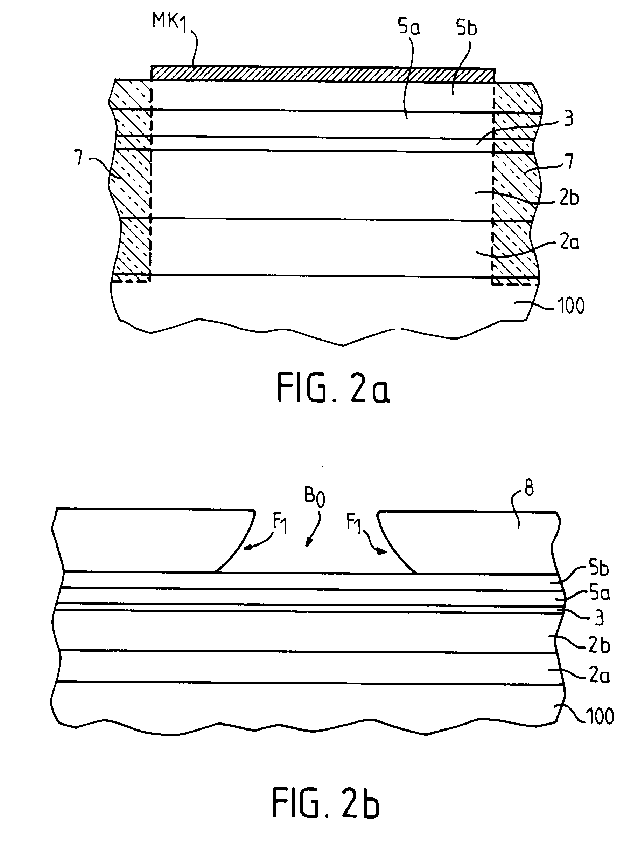

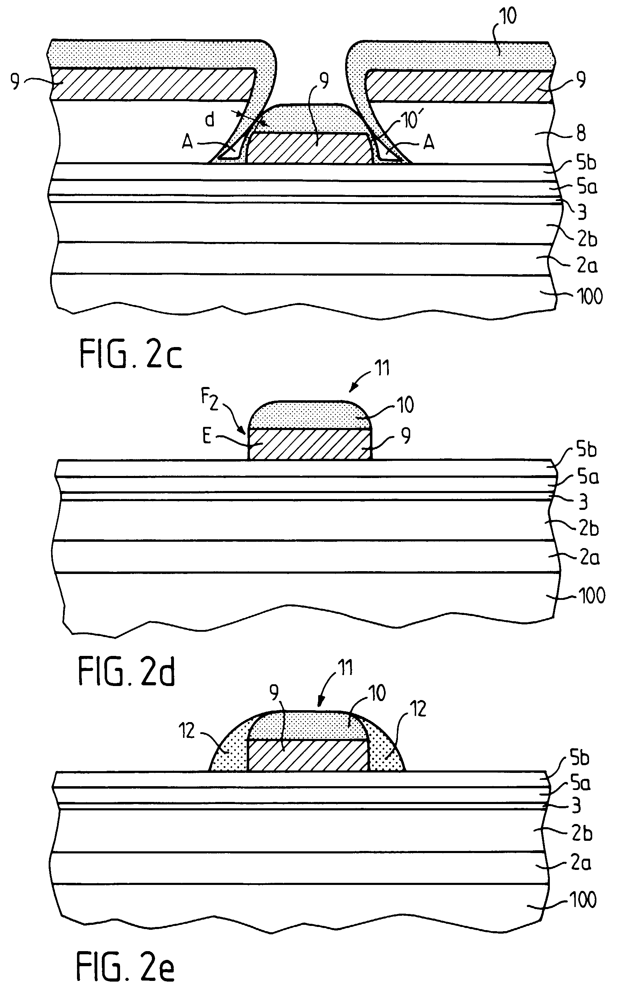

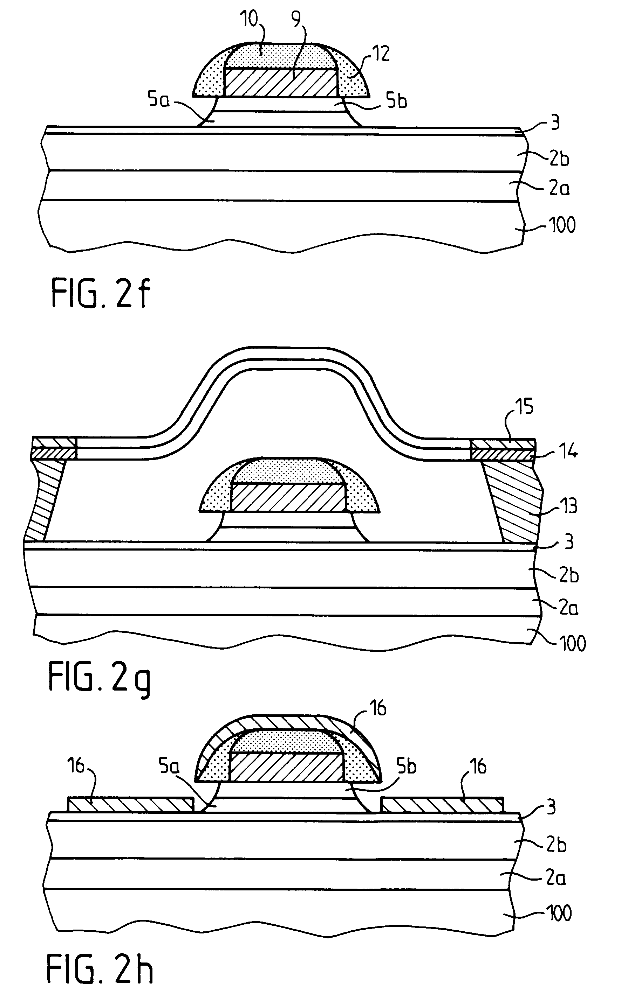

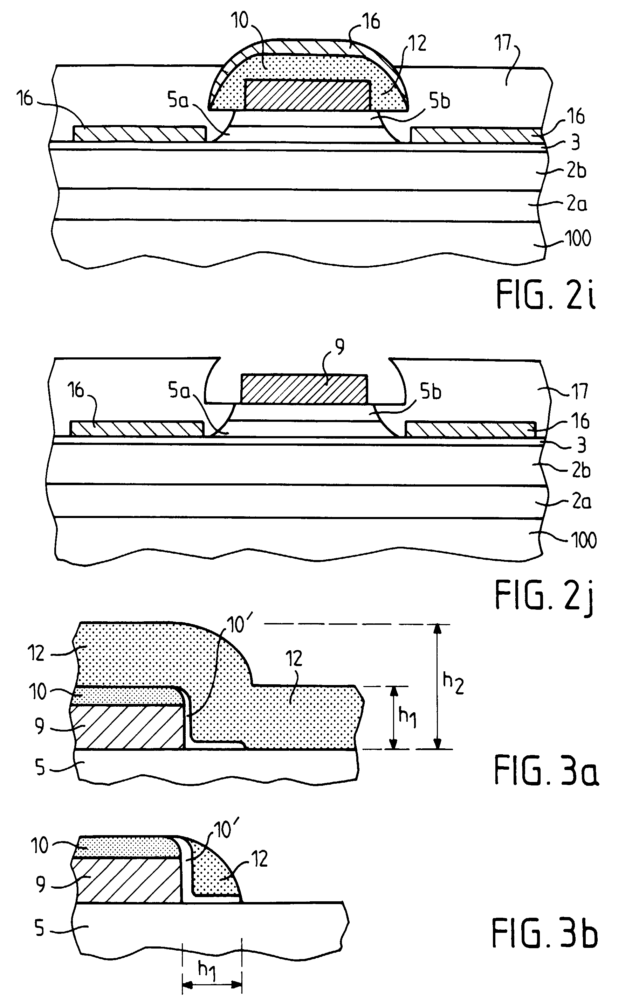

Le procédé selon l'invention comprend essentiellement la réalisation sur des couches semiconductrices respectives 5,3 d'un premier contact d'électrode E 9 encapsulé et muni d'espaceurs, et d'un second contact d'électrode B 16 autoaligné sur le premier contact ainsi équipé, selon la série d'étapes suivantes incluant :
aₒ) la formation d'une première et d'une seconde couches semiconductrices 3 et 5 pour recevoir respectivement le premier et le second contacts d'électrode 9 et 16 ;
bₒ) la formation, par une méthode dite d'inversion d'image, d'une ouverture B₀ dite à flancs F₁ renversés, dans une couche de photorésist 8 déposée sur la première couche semiconductrice 5, ou couche semiconductrice supérieure (voir la figure 2b), cette couche semiconductrice pouvant éventuellement être formée de deux sous-couches 5a et 5b ;
cₒ) le dépôt d'une dite première couche métallique formant, dans cette ouverture B₀, le premier contact d'électrode E, lequel a des flancs F₂ de hauteur inférieure à ceux F₁ de la couche de photorésist 8, flancs F₂ dont les bords supérieurs arrivent latéralement à une dite petite distance d des flancs F₁ renversés de l'ouverture, laissant ainsi une lumière A autour de l'embase du premier contact E, en métal 9 (voir la figure 2c) ;
dₒ) le dépôt d'une dite première couche diélectrique 10 d'une épaisseur supérieure à la grandeur de ladite petite distance d, cette couche diélectrique 10 encapsulant le premier contact E sans emplir la lumière A (voir la figure 2c) et formant un plot 11 ;
eₒ) l'arrachage des couches diélectriques et métalliques 8, 9, 10 par la méthode connue sous le nom anglais de "lift-off", autour du premier contact E restant encapsulé du diélectrique 10 (voir la figure 2d) ;
fₒ) la réalisation d'espaceurs 12 autour du premier contact E encapsulé, (voir la figure 2e).

Dans l'étape bₒ), on peut former par un procédé d'inversion d'image, les flancs F₁ renversés de l'ouverture B₀, soit plans, soit avec une convexité tournée vers l'ouverture B₀ (voir la figure 2b).

Dans ce cas, les bords supérieurs des flancs F₂ du premier contact métallique E arrivent à ladite petite distance latérale d des flancs renversés F₁ de l'ouverture B₀ dans la partie où ces derniers sont convexes.

De préférence, on réalisera les flancs F₁ de l'ouverture B₀, avec une partie supérieure F'₁ sensiblement verticale et une partie inférieure F''₁ montrant une convexité tournée vers l'ouverture B₀. Le procédé pour arriver à ce résultat est décrit plus loin.

Dans ce dernier cas, les bords supérieurs des flancs F₂ arrivent à ladite petite distance d des flancs renversés F₁ de l'ouverture B₀ dans la zone où l'on trouve le changement de pente entre la partie supérieure F'₁ sensiblement verticale et la partie inférieure convexe F''₁ (voir la figure 4c).

Pour réaliser un dispositif non planaire, et en particulier un transistor HBT comme décrit plus loin, on forme la première couche 5 (5a, 5b), en surface de la seconde couche 3. Ces couches présentent des types de conductivité opposés.

Pour autoaligner le second contact B sur le premier E, on reprend le procédé au stade où l'on a formé le plot 11, constitué du contact E du métal 9 et de l'encapsulant 10, et muni des espaceurs 12, et l'on poursuit ce procédé par :
gₒ) la gravure de la première couche semiconductrice dite couche supérieure 5 (5a, 5b) autour du premier contact E d'électrode encapsulé et muni d'espaceurs 12, ce contact ainsi équipé servant de masque, avec sous-gravure sous les espaceurs 12, jusqu'à atteindre la seconde couche semiconductrice sous-jacente 3 (voir la figure 2f) ;
hₒ) le dépôt d'une seconde couche métallique 16 pour constituer le second contact d'électrode B, ce dernier étant délimité d'une part par le premier contact encapsulé 11 et muni d'espaceurs 12 et d'autre part par les bords de l'ouverture d'un masque (voir les figures 2g et 2h) ;
iₒ) l'élimination de l'encapsulant 10, des espaceurs 12, du masque et de la portion de couche métallique 16 déposée sur l'encapsulant 10, les espaceurs 12 et le masque lors de l'étape précédente (voir la figure 1a).

L'élimination des éléments indésirables dans l'étape iₒ), peut se révéler dangereuse pour les matériaux constituant les couches semiconductrices et pour les contacts métalliques. C'est pourquoi selon l'invention, on préconise de réaliser l'étape iₒ) selon la suite d'étapes comprenant :
i₁) le dépôt d'une dite troisième couche diélectrique 17 d'un matériau différent de celui de l'encapsulant et des espaceurs, avec une surface supérieure sensiblement plane, laissant découverte la partie de la seconde couche métallique 16 qui couvre le premier contact d'électrode encapsulé 11 et muni d'espacteurs 12 (voir la figure 2i),
i₂) l'élimination de la partie de la seconde couche métallique 16 qui couvre le premier contact d'électrode encapsulé 11, ce premier contact E étant protégé par les couches 10, 12 et le second contact d'électrode B étant protégé par la troisième couche diélectrique 17 (voir la figure 2j),
i₃) l'élimination des espaceurs 12 et de l'encapsulant 10 du premier contact d'électrode (voir la figure 2j),
i₄) l'élimination de ladite troisième couche diélectrique 17 et le "lift-off" du masque ayant servi à délimiter le second contact B, et de la partie de couche métallique 16 qui le couvre (voir la figure 1a).

Il est évident pour l'homme du métier que l'on pourrait aussi utiliser le plot 11 formé d'un contact E encapsulé par la couche 10, et muni des espaceurs 12, pour réaliser une seconde électrode B autoalignée sur E, les deux électrodes étant réalisées sur des couches adjacentes dont le niveau supérieur est dans un même plan. Dans ce cas, l'avantage principal vient de l'utilisation du procédé d'inversion d'image pour obtenir d'une façon simple un premier contact bien délimité. Un autre avantage vient du fait que le plot 11 formé du premier contact encapsulé présente une forme sans défaut, permettant de réaliser des espaceurs avec une grande précision.

On va montrer ci-après comment appliquer ces étapes essentielles à la réalisation particulière d'un HBT. Le procédé de réalisation d'un tel transistor HBT comprend au moins les étapes suivantes :
a) formation d'un substrat 100 en un matériau semiconducteur monocristallin par exemple du groupe III-V présentant une face supérieure orientée, par exemple selon une direction cristallographique [1 0 0]. Ce substrat est choisi de préférence semi-isolant pour que le procédé se trouve en synergie de fabrication avec les procédés de réalisation des circuits intégrés les plus courants. Le substrat sera comme on l'a dit favorablement en arséniure de gallium (GaAs). Ce substrat est obtenu semi-isolant par exemple par dopage au moyen d'ions fer (Fe). Ce substrat pourra aussi être réalisé en arséniure de gallium dopé à l'indium (In) et recuit, ce qui permet d'obtenir des matériaux dépourvus de dislocations et compatibles avec la croissance ultérieure de couches épitaxiales du groupe III-V ;
b) réalisation de deux couches épitaxiales planes d'arséniure de gallium pour former le collecteur successivement une couche 2a de type de conductivité N⁺ et une couche 2b de type de conductivité N. La croissance épitaxiale de ces couches peut être réalisée en phase vapeur ou en phase liquide. Elle sera réalisée de préférence par une méthode aux organo-métalliques dite MOCVD, ou par MBE. La couche 2a présentera une épaisseur de 0,2 à 1 µm, et de préférence 0,5 µm. Cette couche 2a de type de conductivité N⁺ est obtenue par exemple par un dopage au moyen de l'ion silicium (Si) à environ 3 à 5.10¹⁸ ions par cm³. L'épaisseur de la couche 2b est de l'ordre de 0,3 µm et le type de conductivité N est obtenu par exemple par dopage au moyen de l'ion silicium Si à 5¹⁶ ions par cm³ ;
c) réalisation en surface des deux couches précédentes d'une couche épitaxiale plane 3 d'un matériau ternaire ou binaire du groupe III-V, par exemple l'arséniure de gallium (GaAs), de type de conductivité P⁺ formant la couche de base. La croissance de cette couche épitaxiale sera réalisée par le même procédé choisi pour la croissance des couches 2a et 2b de collecteur.

La couche 3 de base aura une épaisseur de l'ordre de 0,1 µm et sera dopée à l'aide d'ions par exemple Zn ou Mg à une concentration supérieure ou égale à 10¹⁹ par cm³ ;
d) réalisation de deux couches épitaxiales planes superposées, la première 5a d'un matériau ternaire du groupe III-V, par exemple l'arséniure de gallium et d'aluminium (GaAlAs), de type de conductivité N formant la couche d'émetteur, et la seconde 5b d'un matériau binaire ou ternaire, par exemple GaAs ou GaInAs, de type de conductivité N⁺ pour permettre la prise du contact E d'émetteur. La croissance épitaxiale de ces couches sera réalisée par le même procédé choisi pour la croissance des couches précédentes (voir la figure 1a).

La couche d'émetteur 5a aura une épaisseur de l'ordre de 0,15 µm et la couche de contact 5b aura une épaisseur de l'ordre de 0,15 µm. La couche d'émetteur 5a sera dopée à l'aide d'ions par exemple Si à une concentration de l'ordre de 5.10¹⁷ cm³, et la couche de contact 5b à l'aide d'ions Si à une concentration de l'ordre de 2.10¹⁸ par cm³.

La couche d'émetteur 5a en arséniure de gallium et d'aluminium (GaAlAs) présentera de préférence une concentration de 0,25 en aluminium (Al) ;
e) A ce stade du procédé, le dispositif est illustré en coupe par la figure 2a. Cette étape comprend l'implantation d'ions bore (B⁺) pour délimiter la zone active du transistor. Les ions sont implantés avec une énergie et une dose suffisante pour rendre les couches épitaxiées isolantes dans les zones périphériques 7. Ceci sera réalisé de préférence avec une succession de quatre implantations, d'énergie croissante, avec une valeur maximum de 490 KeV, de façon à obtenir dans le matériau une valeur de concentration en bore constante avec la profondeur. Durant l'implantation, la zone active est protégée par un masque MK1 réalisé par exemple en silice (SiO₂) de 2 µm d'épaisseur. Ce masque est enlevé à l'issue de l'opération.

La figure 1b montre vu du dessus en pointillés la région active du transistor délimitée par le masque MK1, les zone externes aux pointillés sont isolées (régions 7) ;
f) Réalisation d'une ouverture B₀ dans une couche 8 de photorésist par photolithographie. Cette ouverture B₀ est réalisée par une méthode dite d'inversion d'image. Selon cette méthode, on obtient une ouverture dite à flancs renversés qui est particulièrement bien adaptée à l'opération de double lift-off qui va suivre. L'ouverture B₀ présente la forme du motif de contact d'émetteur E, et par exemple dans la coupe selon l'axe I-I de la figure 1a, une dimension transversale D.

La méthode dite d'inversion d'image est particulièrement connue de deux publications dans "Proceedings of SPIE", Vol.771 "Advances in resist technology and processing IV" 2-3 mars 1987 Santa Clara, California. La première publication est intitulée "Image reversal : a practical approach to submicron lithography" par Vic Marriot and César M. Garsaand alii. Cette publication se trouve à la page 221 du SPIE Vol.771. La seconde publication est intitulée "Image reversal : a practical approach to lift-off" par Susan K.Jones and Richard C.Chapman. Cette publication se trouve à la page 231 du SPIE Vol .771. Le procédé d'inversion d'image est fondé sur les faits suivants. A ce jour, on a réussi en employant la photolithographie à obtenir des détails submicroniques, mais la demande pour des géométries de l'ordre de 0,5 à 0,8 µm est proche dans le futur et il ne faudra pas attendre longtemps avant que l'on recherche à obtenir des géométries de l'ordre de 0,4 µm. Un certain nombre de techniques sont déjà mises en oeuvre dans l'industrie, par exemple les méthodes par faisceaux d'électrons, rayons X et photorésist multicouches ; cependant la photolithographie avec une simple couche est la plus attractive d'un point de vue industriel. Des progrès ont été accomplis en accroissant l'ouverture numérique des lentilles ou en utilisant des sources lumineuses de longueur d'onde plus courtes. On arrive ainsi avec des photorésists conventionnelles à des longueurs d'onde de 365 nanomètres, mais l'absorption à ces longueurs d'onde limite le contraste et la résolution.

Il a été suggéré que la méthode dite "par inversion d'image" devrait produire un meilleur contraste, ce qui conduirait à une meilleure profondeur de mise au point et un meilleur contrôle de la définition. Le procédé d'inversion d'image à déjà été cité dans la littérature depuis 1960. Un grand nombre d'approches ont été publiées dans les années suivantes. En général la méthode d'inversion d'image comprend l'utilisation d'une amine incorporée dans la photorésist soit avant le revêtement par la photorésist ou bien dans la phase gazeuse après que la résist ait été déposée sur la couche semiconductrice par exemple et exposée à la source lumineuse.Les amines forment un sel d'amines avec un acide carboxilique d'indène qui est formé par l'exposition à la source lumineuse. A hautes températures, il se forme un indène insoluble d'alcali aqueux. Après exposition, la surface préalablement non-exposée est soluble dans un développeur d'alcali aqueux, de sorte que l'image se trouve inversée lors du développement. Avec un tel procédé, la première publication citée indique que l'on peut obtenir des ouvertures de très faibles dimensions notamment submicroniques. Et la seconde publication citée indique que, sous différentes conditions de mise en oeuvre, les flancs de l'ouverture peuvent être, comme montré sur la figure 5 de cette seconde publication, soit positifs, soit verticaux, soit renversés.

Dans la présente invention, on utilisera uniquement les procédés décrits dans les publications citées pour obtenir une ouverture B₀ à flancs renversés F₁ dans la couche 8 de photorésist déposée sur la couche supérieure semiconductrice 5b.

Selon l'invention, on pourra employer directement le procédé de la seconde publication citée qui donne des flancs inversés, mais de préférence, on emploiera un procédé particulier permettant d'obtenir des flancs renversés F₁ qui présentent une concavité dont la partie renflée est tournée vers l'ouverture B₀, et de préférence un procédé qui permet d'obtenir une ouverture B₀ dont la partie supérieure F'₁ des flancs F₁ est sensiblement verticale, et dont la partie inférieure F''₁ est convexe avec des parties renflées tournées vers l'ouverture B₀ (voir la figure 4c).

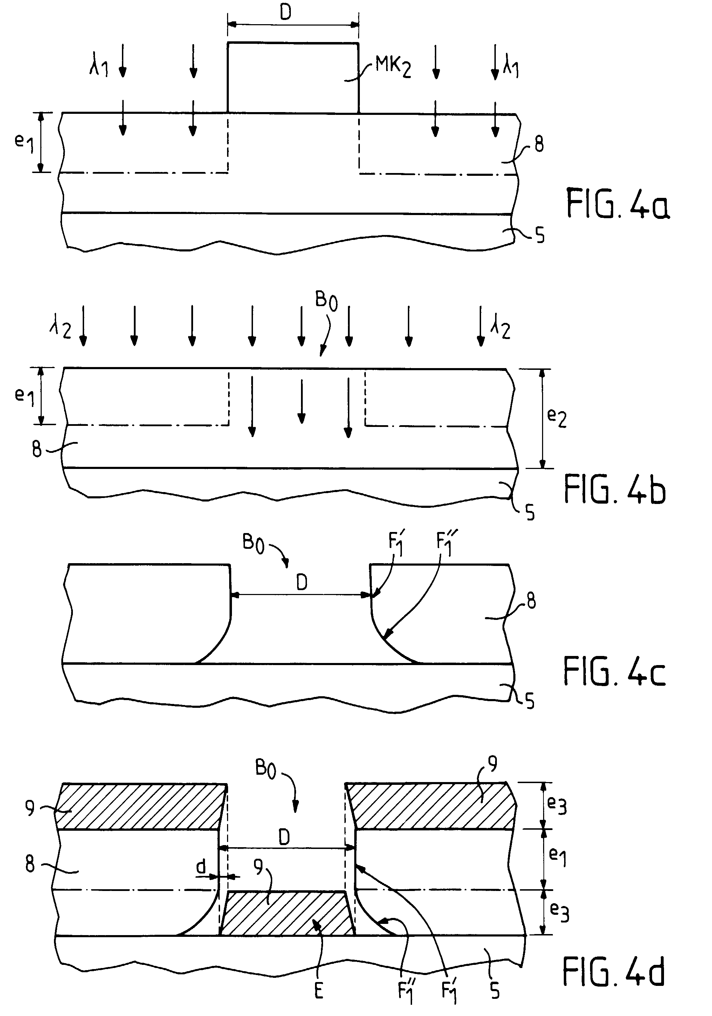

L'ensemble des étapes préférées pour obtenir un tel profil est illustré par les figures 4a à 4c. Pour obtenir ledit profil voulu on procédera de la façon suivante :
- on nettoie d'abord la surface semiconductrice 5b au moyen d'alcool chaud, par exemple,
- on étuve le dispositif pendant environ 10 minutes à 135°C,
- on enduit la surface 5b d'une couche de AZ 5214 E, qui est une résine positive au départ et inversable par traitements, par un procédé dit à la tournette à 7000 tours par minute pendant 40 secondes puis,
- on réalise une cuisson de 30 minutes à 90°C,
- une insolation sous ultraviolets à une longueur d'onde λ₁ de 310 nm, avec une puissance de 80 mJ par cm², de la partie externe à l'ouverture B₀, en masquant cette dernière au moyen d'un masque MK₂ de dimension transversale D (voir la figure 4a). Cette opération permet l'insolation de la résine, en dehors de la région B₀ couverte par MK₂, sur une épaisseur e₁ correspondant à la hauteur voulue ultérieurement, pour les parties F'₁ sensiblement verticales des flancs de l'ouverture B₀. Puis le masque MK₂ est éliminé,
- un recuit d'inversion de 15 mn à 120°C,
- une insolation aux rayons ultraviolets à une longueur d'onde λ₂ de 365 nm (λ₂ ≥ λ₁) avec une puissance de 150 mJ, qui permet d'insoler toute l'épaisseur e₂ de la résine dans la région B₀, alors que les régions externes ont été durcies au cours des opérations précédentes (voir la figure 4b),
- un développement pendant 2 mn 15 dans une solution formée du mélange de 200 ml de MF 312 + 250 ml de H₂O₂. Cette opération élimine la résine dans la région B₀ (voir la figure 4c). La partie supérieure d'épaisseur e₁ de la résine 8 qui a été durcie par les premières opérations, forme des flancs F'₁ pratiquement verticaux. La partie inférieure de la résine 8 qui a seulement été insolée, forme par sous-gravure des flancs F''₂ convexes dont la partie renflée est tournée vers l'ouverture B₀. Donc l'ouverture B₀ a une dimension transversale D dans sa partie supérieure. On peut se procurer dans le commerce la résine AZ 5214 E chez HOECHST Celanese Corp. Route 202-206 North P.O-Box 2500, Sommerville, New Jersey 08876. On peut d'autre part se procurer dans le commerce le MF312 chez le fabricant SHIPLEY COMPANY INC. NEWTON-MASSACHUSETTS,
- désoxydation au moyen de NH₄OH à 5 % pendant 1 mn + un premier rinçage suivi d'un second rinçage dans l'eau 18 MΩ.

g) Dépôt d'une couche métallique 9 destinée à la formation d'un contact ohmique E sur la couche d'émetteur et qui sera constituée de préférence de la façon suivante : AuGe 85 nm/Ni 10 nm/Ti 100 nm/Au 200 nm, soit au total environ 395 nm (voir la figure 4d). On constate que lors du dépôt de la couche métallique 9, la base du dépôt correspond exactement à la dimension transversale D. Mais au fur et à mesure que la couche métallique 9 croît, elle tend à étrécir l'ouverture B₀, en sorte que lorsque l'épaisseur voulue pour cette couche, qui est e₃ = e₂-e₁, est atteinte, la partie supérieure de l'ouverture B₀ est inférieure à la valeur D primitive. Il en résulte que les flancs F₂ du plot E de métal 9 qui se dépose dans l'ouverture B₀ sont légèrement inclinés, que la partie supérieure du plot E est de dimension inférieure à son embase et que l'arête supérieure du plot E se trouve séparée des flancs F₁ de l'ouverture B₀ par une petite distance d (voir la figure 4d).

Cette petite distance d ainsi formée est la clé de la suite du procédé dit de double lift-off.

Bien entendu, la manière de réaliser la petite distance d a été décrite ici avec des matériaux particuliers, à titre d'exemple, et des étapes exemplatives. Mais l'homme du métier peut trouver facilement des matériaux équivalents pour mettre ces étapes en oeuvre d'une manière similaire.

De même, comme on l'a dit ce procédé n'est pas exclusif d'un HBT.

Quelle que soit la méthode, il est important pour cette étape que le profil F₁ de laque 8 et l'épaisseur du dépôt métallique 9 soient choisis de façon que la distance d entre le flanc renversé F₁ de la couche de laque 8 et l'arête supérieure du dépôt métallique 9 soit très petite et qu'à l'issue de cette étape, vu la forme respective des flancs F₁ et F₂, il existe une lumière A entre les flancs F₁ renversés de la couche de laque 8 et les flancs F₂ du plot métallique 9 d'émetteur E.
h) Dépôt d'une couche de silice (SiO₂) 10 d'une épaisseur de l'ordre de 350 nm par la technique de dépôt chimique en phase vapeur assistée par plasma (PECVD) à 80°C. Comme la distance d entre les flancs renversés F₁ de la couche de laque 8 et l'arête supérieure du dépôt métallique 9 dans l'ouverture B₀ est très petite, cet intervalle se bouche rapidement lors du dépôt de la silice 10, ce qui fait que la quantité de silice présente dans la lumière A, tel qu'illustré sur la figure 2c, est très limitée.
i) Elimination de la couche de métal 9, et de silice 10, dans les zones situées en dehors du contact d'émetteur E, par dissolution de la résine 8 dans l'acétone, ce qui est la technique dite de lift-off. A l'issue de cette opération, on conserve le contact d'émetteur E en métal 9 encapsulé par une couche de silice 10 formant un plot dit de contact d'émetteur encapsulé 11. Du fait de la présence des lumières A non comblées par la couche de silice 10 lors du dépôt de cette dernière, cette opération de lift-off est facilitée et notamment des liserés qui risquaient d'apparaître en bordure du motif 11 sont évités. Ainsi le motif d'émetteur encapsulé présente une forme quasi-parfaite.

Eventuellement, la couche de silice 10' de faible épaisseur entourant les flancs du contact d'émetteur peut être éliminée par une légère gravure en voie sèche faite par une méthode RIE au moyen des gaz CHF₃-SF₆. A ce stade du procédé le dispositif est illustré par la figure 2d. Si l'on choisit de conserver la couche 10', il faut savoir qu'elle est de l'ordre de 20 à 30 nm, soit 10 fois plus fine que les épaisseurs de couches de matériau diélectrique mises en jeu pour réaliser les espaceurs. Il suffira alors, lors de l'étape suivante de prolonger très légèrement la gravure résultant dans la formation des espaceurs 12, pour obtenir ces dernières de dimension voulue.
j) Réalisation autour des contacts d'émetteur 11, comprenant la métallisation 9 et la couche d'encapsulation 10, d'espaceurs 12 par exemple en silice SiO₂. Cette étape est illustrée par la figure 2e. Une technique pour la réalisation d'espaceurs est décrite par exemple dans la demande de brevet européen N° 0 322 960 A1. Ce document fait référence à une technique décrite dans la publication intitulée "Edge-defined Patterning of Hyperfine Refractory Metal Silicide Mos Structure" par SHINIJI OKAZAKI dans IEEE Transactions on Electron Devices, Vol.ED28, n°11, Novembre 1981, pp. 1364-1368. Dans le brevet cité, les espaceurs 12 étaient réalisés au moyen de nitrure de silicium. Dans la présente application, on choisira de préférence la silice (SiO₂), c' est-à-dire le même matériau diélectrique que la couche d'encapsulation 10 du contact d'émetteur E formant le plot 11 déjà réalisé. La technique de réalisation d'espaceurs sera mieux comprise en considérant les figures 3a et 3b.

Telle que représentée sur la figure 3a une couche 12 de matériau diélectrique SiO₂ est déposée de façon uniforme sur le dispositif et d'une épaisseur spécifique très précise h₁ choisie pour la dimension dont doit être séparée l'électrode de base B, ultérieurement façonnée, du contact d'émetteur E. Le dépôt uniforme de la couche 12 fait qu'elle suit très précisément les détails et reliefs du dispositif tel que réalisé dans les étapes précédentes. L'épaisseur totale des couches 9, 10, 12 est h₂. On pratique ensuite sur le dispositif une gravure uniforme, par exemple une gravure ionique réactive RIE telle qu'une épaisseur identique de matériau 12 est enlevée en chaque point.

L'épaisseur de matériau 12 étant pratiquement égale à h₂ le long des flancs du plot 11, comme il est montré sur la figure 3a, après cette gravure, il reste, le long de ces flancs, une portion de la couche diélectrique 12 qui est appuyée le long de ces flancs et qui a pour dimension latérale perpendiculairement à ces flancs F₂ la dimension spécifique h₁. A l'issue de cette gravure le dispositif est tel qu'illustré par la figure 3b. La portion de couche 12 restante appuyée le long des flancs du plot 11 prend le nom d'espaceur.

L'espaceur remplit ici deux fonctions :
- éviter que les réactifs utilisés pour la gravure du doigt d'émetteur E n'entrent en contact avec la couche métallique 9 de contact d'émetteur, et qu'ainsi la réaction de gravure des couches d'émetteur 5a et 5b ne soit perturbée,
- éviter que le plot 11 lui-même ne surplombe le flanc de gravure des couches 5a, 5b, c'est-à-dire qu'il se produise dans les étapes ultérieure une sous-gravure du contact d'émetteur lui-même,
- éloigner les contacts d'émetteur et de base l'un de l'autre pour réduire les risques de court-circuits,
- délimiter avec précision la distance entre le contact d'émetteur E et le ou les contacts de base B réalisé(s) ultérieurement. La dimension h₁ des espaceurs est choisie en fonction du procédé de gravure des couches d'émetteur 5a et 5b utilisées. Dans l'exemple de réalisation décrit ici, la gravure est réalisée en voie humide ; dans ces conditions la gravure latérale est très voisine de la profondeur de gravure, ce qui impose que les espaceurs aient une épaisseur de l'ordre de 0,5 µm. Cette épaisseur peut être réduite ; par exemple être de l'ordre de 0,1 µm, si l'on choisit au contraire de réaliser la gravure par voie sèche, par exemple par RIE, de façon anisotrope.

La gravure de la couche 12 dans l'étape de réalisation des espaceurs eux-mêmes est réalisée de préférence par voie sèche par RIE au moyen des gaz CHF₃ et SF₆ ;
k) Gravure des couches d'émetteur 5a et 5b jusqu'à découvrir la couche de base 3, le plot 11 avec les espaceurs 12 servant de masque. Cette gravure se fait en deux étapes dans le mode de réalisation présenté ici, mais d'autres possibilités existent, faisant appel à des solutions de gravure différentes. La couche de surface 5b est gravée de façon sélective par rapport à la couche 5a à l'aide d'une solution NaOH (20 ml 0,5 N)/H₂O₂ (200 ml). La couche 3 de base est gravée à l'aide de la solution NH₄OH (30 ml)/H₂O₂ (1 ml)/H₂O (500 ml) à température ambiante. Cette étape est illustrée par la figure 2f ;
ℓ) Définition du motif de métallisation de base B ou contact de base B dans une couche de résine photosensible par un procédé de photolithographie connu en soi de l'homme du métier. Cette étape est illustrée par la figure 2g. On utilisera de préférence un système tricouche composé de :
   - une couche de résine 13 (PMMA 9 % 496 K) (Polyméthylmétacrylate de concentration 9 % et poids moléculaire 496),
   - une couche de nitrure (Si₃N₄)14,
   - une couche de résine AZ407015, du même fabricant que la résine AZ 5214 E citée précédemment,
   - le motif est d'abord défini dans la couche 15 par photolithographie. Ensuite la couche 14 est gravée par RIE, la couche 15 servant de masque. La couche de résine 13 est insolée à travers l'ouverture développée. Cette technique permet de définir un profil en surplomb qui est indispensable pour obtenir une bonne découpe du film métallique, notamment au niveau du passage de la marche constituée par le doigt d'émetteur surmonté du plot métal-silice comme montré sur la figure 2g. Par doigt d'émetteur il y lieu d'entendre les couches 5a et 5b qui forment l'émetteur, la couche métallique 9 étant le contact E d'émetteur ;
m) Dépôt d'une couche métallique 16 appropriée à former les contacts de base B. La couche métallique 16 pourra être favorablement composée d'Or-Manganèse (Au-Mn), d'Or-Béryllium (Au-Be), d'Or-Zinc (Au-Zn). Ce sera de préférence Au-Mn à 4 % qui permet d'obtenir un contact de faible résistivité. Le motif de métallisation de base B est délimité par l'ouverture dans le tricouche 13, 14, 15 décrit précédemment et par le doigt d'émetteur surmonté de l'encapsulant en silice 10 et muni des espaceurs 12. Le métal en dehors de ce motif est éliminé ensuite par une technique connue en soi de "lift-off" comme montré sur la figure 2h.
n) Dépôt d'une couche de résine 17 positive de l'ordre de 1 µm d'épaisseur par exemple en AZ 4110 et planarisation de cette couche par une succession d'expositions aux rayonnements ultraviolets dans les longueurs d'onde 310 nm suivis de recuits à haute température dans le domaine 150 à 180°C, étapes qui font fluer la résine. Une légère gravure par RIE permet d'éliminer la couche de résine restant en surface du plot 11 et permet ainsi de dégager la surface de la couche métallique 16 comme il est montré sur la figure 2i ;
o) Gravure dans la zone découverte de la couche métallique 16, à l'aide d'une solution de KI-I₂ et gravure de la couche de silice SiO₂ formant l'encapsulant 10 et les espaceurs 12 à l'aide d'une solution tampon d'acide fluorhydrique. La résine 17 est ensuite éliminée par dissolution dans l'acétone. Cette étape est illustrée par la figure 2j.

Par ce procédé, les métallisations 9,16 de contact d'émetteur E et de base B sont constamment protégées durant les opérations de même que les couches 5a et 5b formant l'émetteur.
p) Définition du motif de contact de collecteur C dans une couche de résine positive d'une épaisseur environ 2 µm, par exemple d'AZ4210, par photolithographie. On effectue ensuite dans les ouvertures du masque ainsi obtenu, la gravure des couches de base 3 et de collecteur 2b pour atteindre la couche de contact de collecteur 2a. Cette étape n'est pas illustrée.

La gravure est faite par exemple en voie humide, par un mélange acide citrique dilué/eau oxygénée (H₂O₂) dans les proportions 1kg/ℓ;
q) dépôt d'une couche métallique 19 propre à former les contacts de collecteur C. Le métal déposé en dehors du motif de collecteur est éliminé par "lift-off" en dissolvant la couche de résine dans l'acétone, comme montré sur la figure 1a. Le métal pour constituer la couche 19 de contact C sera de préférence le multicouche déjà utilisé pour réaliser le contact E d'émetteur, c'est-à-dire Au-Ge (85 nm)/Ni (10 nm)/Ti (100 nm)/Au (200 nm). L'ensemble des contacts E,B,C des électrodes sera recuit en même temps en fin de procédé à une température de 370°C pendant environ 30 secondes.

Comme on l'a dit précédemment la figure 1b représente vu du dessus un exemple de réalisation du transistor HBT utilisant le procédé de réalisation selon l'invention. la ligne en traits discontinus représente les bords du masque MK1 qui couvrait la zone active durant l'étape e) et qui délimite de ce fait la zone active. D'autres formes de transistor sont possibles et notamment d'autres configurations des électrodes. D'autres matériaux peuvent aussi être envisagés pour réaliser un transistor, la structure pouvant comporter ou non une ou plusieurs hétérojonctions.

On a vu d'autre part que la réalisation décrite du plot de contact d'émetteur encapsulé et entouré d'espaceurs pouvait être utilisée pour réaliser un dispositif planaire par exemple un HBT planaire de la structure de celui qui était connu du brevet européen EP 0 322 960 A1.

Un transistor bipolaire à hétérojonction réalisé selon l'invention présente de nombreux avantages, en effet il présente un auto-alignement des contacts B de base sur le contact E d'émetteur, ce qui permet de réduire les résistances d'accès de base et est essentiel pour améliorer la fréquence d'utilisation de ce type de transistor.

Le type de procédé selon l'invention est particulièrement avantageux car il permet d'éviter en protégeant le contact d'émetteur durant le procédé que cette métallisation d'émetteur induise dans la solution de gravure des effets électrochimiques qui perturberaient le profil de gravure, alors qu'un contrôle parfait de ce profil est nécessaire pour l'auto-alignement du contact de base. Selon l'invention également les électrodes d'émetteur et de base sont très proches sans que la métallisation d'émetteur ou celle de base risque d'entrer en court-circuit. On a évité aussi que la métallisation d'émetteur ne soit en surplomb au-dessus du flanc de gravure, ce qui lors du recuit de contact ohmique pourrait induire le métal à fluer ou à diffuser le long de ce flanc. Ceci tendrait à créer des courants de fuite et à réduire la tension de claquage émetteur-base.

## Revendications

1. Procédé de réalisation d'un dispositif semiconducteur du type transistor biplaire à hétérojonction (HBT) comprenant, pour former des contacts d'électrodes d'émetteur et de base autoalignés, des étapes de :
aₒ) empilement sur un substrat d'au moins trois couches semiconductrices, de types de conductivité alternés, pour former respectivement à partir dudit substrat les couches de collecteur, base et émetteur du transistor ;
bₒ) dépôt en surface de la couche supérieure (5a; 5b) d'émetteur, désignée par première couche semiconductrice, d'une couche de photorésist (8), et formation dans ladite couche de photorésist (8) d'une ouverture (Bₒ) délimitant la région d'un premier contact d'électrode,
caractérisé en ce que :
ledit premier contact d'électrode est le contact d'émetteur du transistor,
en ce que, dans l'étape bₒ) l'ouverture (Bₒ) est réalisée dans la couche de photorésist (8) par une méthode désignée par méthode d'inversion d'image, selon laquelle l'ouverture formée a des flancs renversés (F₁), i.e ayant une convexité dont la partie renflée est tournée vers ladite ouverture (Bₒ),
et en ce que le procédé se poursuit par les étapes de :
cₒ) dépôt, en surface de ladite couche de photorésist (8) et directement en surface de ladite première couche semiconductrice d'émetteur (5 ; 5b) d'une première couche métallique (9) pour former ledit premier contact d'émetteur (E) délimité par la partie supérieure de ladite ouverture (Bₒ), ledit premier contact d'émetteur (E) ayant une hauteur inférieure à l'épaisseur de la couche de photorésist (8) et ayant des flancs (F₂) qui, dans leur partie supérieure arrivent à une petite distance (d) non nulle des flancs renversés (F₁) de l'ouverture (Bₒ), et qui dans leur partie inférieure laissent une lumière (A) avec la partie inférieure desdits flancs renversés (F₁),
dₒ) dépôt d'une couche diélectrique (10) désignée par première couche diélectrique, d'une épaisseur supérieure à la dite distance d'affleurement (d), couvrant la première couche métallique sans emplir la lumière (A),
eₒ) arrachage de la couche de photorésist (8) entraînant ladite première couche métallique (9) et ladite première couche diélectrique (10), autour dudit premier contact d'émetteur (9), lequel reste couvert d'une partie de la première couche diélectrique (10) désignée par encapsulant,
fₒ) dépôt d'une couche diélectrique, désignée par seconde couche diélectrique, d'une épaisseur uniforme de valeur spécifique (h₁), puis gravure de cette seconde couche diélectrique (12) uniformément d'une hauteur égale à la valeur spécifique (h₁), pour former autour du premier contact d'émetteur (9) des espaceurs (12) de dimension latérale égale à ladite valeur spécifique (h₁),
gₒ) gravure de la première couche semiconductrice d'émetteur (5a, 5b), autour du premier contact (9) d'émetteur (E) muni de l'encapsulant (10) et des espaceurs (12), ce contact ainsi équipé constituant un premier masque (11) pour ladite gravure, jusqu'à atteindre la couche semicondrice (3) sous-jacente de base, désignée par seconde couche semiconductrice, ladite gravure incluant une sous-gravure sous lesdits espaceurs (12),
hₒ) dépôt d'une seconde couche métallique (16) pour former ledit second contact de base (B), délimité d'une part par ledit premier masque (11) formé du premier contact d'émetteur (E) muni de l'encapsulant et des espaceurs, et d'autre part par les bords de l'ouverture d'un second masque ;
iₒ) arrachage de l'encapsulant (10), des espaceurs (12) et du second masque entraînant la portion de couche métallique (16) déposée sur ledit encapsulant, sur lesdits espaceurs et sur ledit second masque lors de l'étape précédente.

2. Procédé selon la revendication 1, caractérisé en ce que dans l'étape bₒ), on forme les flancs renversés de l'ouverture (Bₒ) dans la couche de photorésist avec une partie supérieure (F'₁) sensiblement verticale et une partie inférieure (F"₁) ayant une convexité dont la partie renflée est tournée vers l'ouverture (Bₒ),

3. Procédé de réalisation selon la revendication 2, caractérisé en ce que, pour obtenir que les flancs de l'ouverture (Bₒ) présentent une partie supérieure (F'₁) sensiblement verticale et une partie inférieure (F"₁) ayant une convexité tournée vers l'ouverture (Bₒ), on procède par inversion d'image selon au moins les étapes suivantes :
- on enduit la surface supérieure de la première couche semiconductrice, au moyen d'une photorésist de type positif inversable par traitements, dans laquelle on se propose de réaliser l'ouverture (Bₒ) à flancs renversés, et on fait subir à cette photorésist un premier recuit,
- on réalise un masque pour protéger la surface de la région de la photorésist destinée à former ultérieurement l'ouverture (Bₒ) ;
- on insole la photorésist, sur une épaisseur e₁ inférieure à son épaisseur totale, et environ égale à la hauteur voulue pour la partie (F'₁) des flancs verticaux de l'ouverture (Bₒ), au moyen d'un premier rayonnement ultraviolet d'une première longueur d'onde (λ₁) ;
- on élimine le masque précédent et on recuit la photorésist pour la durcir dans les régions insolées ;
- on insole la totalité de la photorésist sur toute son épaisseur, les régions extérieures à la région de la future ouverture (Bₒ) étant devenues, par les opérations précédentes, un masque pour l'opération présente, au moyen d'un rayonnement ultraviolet à une seconde longueur d'onde supérieure ou égale à la première longueur d'onde (λ₂ ≥ λ₁) ;
- on développe la photorésist dans un agent apte à dissoudre les régions insolées non ultérieurement recuites, c'est-à-dire la région de l'ouverture (Bₒ), résultant en une ouverture à flancs (F'₁) sensiblement verticaux dans la partie insolée sur une faible épaisseur et recuite après insolation, et des flancs (F"₁) sous-gravés dans la partie insolée sur toute l'épaisseur sans cuisson ultérieure à l'insolation.

4. Procédé selon l'une des revendications 2 ou 3, caractérisé en ce que dans l'étape cₒ), les bords supérieurs des flancs (F₂) du premier contact métallique (E) affleurent avec ladite petite distance latérale d les flancs renversés (F₁) de l'ouverture (Bₒ), dans la partie où ces derniers présentent leur changement de pente entre la partie verticale et la partie convexe (F'₁ et F"₁).

5. Procédé selon l'une des revendications 1 à 4, caractérisé en ce que dans l'étape fₒ), on forme les espaceurs par dépôt d'une dite seconde couche diélectrique d'un matériau identique à celui de la première couche diélectrique.

6. Procédé de réalisation selon l'une des revendications 1 à 5 caractérisé en ce que dans l'étape iₒ), l'arrachage des éléments indésirables comprend :
i₁) le dépôt d'une dite troisième couche diélectrique d'un matériau différent de celui de l'encapsulant et des espaceurs, avec une surface supérieure sensiblement plane, laissant découverte la partie de la seconde couche métallique qui couvre le premier contact (E) d'émetteur encapsulé,
i₂) l'élimination de la partie de la seconde couche métallique qui couvre le premier contact E d'émetteur encapsulé, ce premier contact étant protégé par son encapsulant et le second contact de base (B) étant protégé par la troisième couche diélectrique,
i₃) l'élimination des espaceurs et de l'encapsulant du premier contact d'émetteur (E),
i₄) l'élimination de ladite troisième couche diélectrique et le "lift-off" du masque et de la partie de couche métallique qui le couvre.

7. Procédé selon la revendication 8, caractérisé en ce que dans l'étape i₁, la troisième couche diélectrique est réalisée par une méthode de planarisation, par exemple en photorésist ou en polyimide.

8. Procédé selon l'une des revendications 6 ou 7, caractérisé en ce que dans l'étape i₂), l'élimination de la portion de couche métallique est faite par voie chimique.

9. Procédé selon l'une des revendications 1 à 8, caractérisé en ce que, dans l'étape fₒ) la grandeur spécifique h₁ est prévue égale à la distance voulue entre le contact d'émetteur et le contact de base.

10. Procédé de réalisation selon l'une des revendications 1 à 9, caractérisé en ce que les couches semiconductrices comportent une hétérojonction entre la couche de base et la couche d'émetteur.

11. Procédé de réalisation selon l'une des revendications 1 à 10, caractérisé en ce que, pour former les contacts de collecteur (C) du transistor bipolaire à hétérojonction, dit troisième contact d'électrode, il comprend en outre :
jₒ) la formation d'un masque avec des ouvertures coïncidant avec les régions prévues pour les contacts de collecteur (C),
kₒ) la gravure des couches semiconductrices dans ces ouvertures jusqu'à la couche de collecteur,
ℓₒ) le dépôt d'une troisième couche métallique pour former les contacts de collecteur,
mₒ) le "lift-off" du masque et de la portion de troisième couche métallique indésirable qui le recouvre.

## Patentansprüche

1. Verfahren zur Herstellung einer Halbleitervorrichtung vom Typ Heteroübergang-Bipolartransistor (HBT), das zur Bildung der automatisch justierten Emitter- und Basen-Kontaktelektroden aus folgenden Schritten besteht :
aₒ) Aufeinanderschichtung von mindestens drei Halbleiterschichten vom Typ wechselnder Konduktivität zur jeweiligen Bildung aus dem Substrat der Kollektor-, der Basen- und der Emitterschicht des Transistors,
bₒ) Aufbringung auf die Oberfläche der oberen, erste Halbleiterschicht bezeichneten Emitterschicht (5a; 5b) einer Fotoresistschicht (8) und Bildung in der besagten Fotoresistschicht (8) eine Öffnung (Bₒ) zur Eingrenzung des Bereichs einer ersten Kontaktelektrode,
mit dem Merkmal, daß :
bei Schritt bₒ) die Öffnung Bₒ) mit einer Bildumkehrmethode bezeichneten Methode in die Fotoresistschicht (8) eingebracht wird, wobei die gebildete Öffnung umgekehrte Seiten (F₁) hat, d.h. eine konvexe Form, deren gewölbter Teil zu der besagten Öffnung (Bₒ) gerichtet ist,
und die Schritte folgendermaßen verlaufen :
cₒ) Aufbringung auf die Oberfläche der besagten Fotoresistschicht (8) und direkt auf die Oberfläche der besagten ersten Emitter-Halbleiterschicht (5; 5b) einer ersten Metallschicht (9) zur Bildung des ersten Emitterkontakts (E), begrenzt durch den oberen Teil der besagten Öffnung (Bₒ), der erste Emitterkontakt (E) hat eine unter der Stärke der Fotoresistschicht (8) liegende Höhe und Seiten (F₂), die an ihrem oberen Teil mit geringem Abstand (d) ungleich Null an die umgekehrten Seiten (F₁) der Öffnung (Bₒ) reichen, und die in ihrem unteren Teil eine Öffnung (A) zu dem unteren Teil der umgekehrten Seiten (F₁) lassen,
dₒ) Aufbringung einer erste Nichtleiterschicht (10) bezeichneten Nichtleiterschicht mit einer über der Berührungsdistanz (d) liegenden Stärke, die die erste Metallschicht ohne Füllung der Öffnung (A) deckt,
eₒ) Entfernung mit der Fotoresistschicht (8) der besagten ersten Metallschicht (9) und besagter erster Nichtleiterschicht (10) um den besagten ersten Emitterkontakt (9), der von einem Teil der ersten mit gekapselt bezeichneten Nichtleiterschicht (10) bedeckt bleibt,
fₒ) Aufbringung einer mit zweite Nichtleiterschicht bezeichneten Nichtleiterschicht einer dem spezifischen Wert (h₁) entsprechenden Stärke, dann einheitliche Gravur dieser zweiten Nichtleiterschicht (12) einer dem spezifischen Wert (h₁) entsprechenden Höhe, zur Bildung um den ersten Emitterkontakt (9) von Distanzstücken (12) mit seitlicher, dem besagten spezifischen Wert (h₁) entsprechenden Abmessung,
gₒ) Gravur der ersten Emitter-Halbleiterschicht (5a, 5b) um den ersten, gekapselten (10) und mit den Distanzstücken (12) versehenen Kontakt (9) des Emitters (E), dieser so ausgerüstete Kontakt bildet eine erste Maske (11) für die besagte Gravur bis zur darunterliegenden, zweite Halbleiterschicht (3) benannten Basen-Halbleiterschicht, die besagte Gravur beinhaltet eine Untergravur unter den besagten Distanzstücken (12),
hₒ) Aufbringung einer zweiten Metallschicht (16) zur Bildung des besagten zweiten Basenkontakts (B), einerseits begrenzt durch die besagte erste Maske (11), gebildet vom ersten gekapselten und mit Distanzstücken versehenen Emitterkontakt (E), und andererseits von den Rändern der Öffnung einer zweiten Maske,
iₒ) Entfernung mit der Kapselung (10), der Distanzstücke (12) und der zweiten Maske des Teils der auf der besagten Kapselung, der besagten Distanzstücke und der besagten zweiten Maske beim vorhergehenden Schritt aufgebrachten Metallschicht (16).

2. Verfahren laut Anspruch 1, mit dem Merkmal, daß in Schritt bₒ die umgekehrten Seiten der Öffnung (Bₒ) in der Fotoresistschicht gebildet werden, mit einem oberen, deutlich vertikalen Teil (F'₁) und einem unteren Teil (F"₁) mit einer konvexen Form, deren gewölbter Teil zur Öffnung (Bₒ) gerichtet ist.

3. Herstellungsverfahren laut Anspruch 2, mit dem Merkmal, daß für den Erhalt an den Öffnungen (Bₒ) der Seiten eines oberen, deutlich vertikalen Teils (F'₁) und eines unteren Teils (F"₁) mit einer konvexen, zur Öffnung (Bₒ) gerichteten Form mindesten nach folgenden Schritten des Bildumkehrverfahrens vorgegangen wird :
- Beschichtung der Oberfläche der ersten Halbleiterschicht mit einem positiven, durch Behandlung umkehrbaren Fotoresists, in das die Vornahme der Öffnung (Bₒ) umgekehrter Seiten vorgeschlagen wird, und Unterziehung dieses Fotoresists einer ersten Nachhärtung,
- Erstellung einer Maske für den Schutz der Oberfläche des Bereichs des Fotoresists, zur Bildung der späteren Öffnung (Bₒ) bestimmt,
- Insolierung des Fotoresists auf einer zur Gesamtstärke geringeren Stärke e₁, etwa der für den Teil (F'₁) gewünschten Höhe der vertikalen Seiten der Öffnung (Bₒ) entsprechend, mit einer ersten Ultraviolettstrahlung einer ersten Wellenlänge (λ₁),
- Entfernung der vorhergehenden Maske und Nachhärtung des Fotoresists zur Härtung in den insolierten Bereichen,
- Insolierung der Gesamtheit des Fotoresists über die gesamte Stärke, aus den äußeren Bereichen des Bereichs der zukünftigen Öffnung (Bₒ) wurde durch die vorhergehenden Verfahren eine Maske für die aktuellen Verfahren, mit einer Ultraviolettstrahlung einer Dauer, die gleich der Dauer der ersten Welle ist oder eine Sekunde darüber liegt (λ₂ ≥ λ₁),
Entwicklung des Fotoresist in einem geeigneten Mittel zur Lösung der insolierten, zuvor nicht nachgehärteten Bereiche, d.h. in dem Bereich der Öffnung (Bₒ), was eine deutlich vertikale Öffnung in den Seiten (F'₁) in dem Bereich ergibt, der über eine geringe Stärke insolierten und nach der Insolation nachgehärteten wurde, und untergravierte Seiten (F"₁) in dem Bereich ergibt, der über die gesamte Stärke ohne vorherige Kochung vor der Insolierung insoliert wurde.

4. Verfahren laut einem der Ansprüche 2 oder 3, mit dem Merkmal, daß bei Schritt cₒ) die oberen Ränder der Seiten (F₂) des ersten Metallkontakts (E) an den besagten kleinen seitlichen Abstand d der umgekehrten Seiten (F₁) der Öffnung (Bₒ) in dem Bereich anliegen, in dem diese ihr Neigungsniveau zwischen dem vertikalen Bereich und dem Bereich konvexer Form aufweisen (F'₁ und F"₁).

5. Verfahren laut einem der Ansprüche 1 bis 4, mit dem Merkmal, daß bei Schritt fₒ) durch Aufbringen einer sogenannten zweiten Nichtleiterschicht aus einem dem der ersten Nichtleiterschicht identischen Material die Distanzstücke gebildet werden.

6. Verfahren laut einem der Ansprüche 1 bis 5, mit dem Merkmal, daß bei Schritt iₒ) das Entfernen der unerwünschten Elemente folgendes beinhaltet :
i₁) Aufbringung einer besagten dritten Nichtleiterschicht eines von der Kapselung und den Distanzstücken unterschiedlichen Materials mit einer oberen, deutlich ebenen Fläche, die den Teil der zweiten Metallschicht frei läßt, der den ersten gekapselten Emitterkontakt (E) bedeckt.
i₂) Entfernung der zweiten, den ersten gekapselten Emitter (E) bedeckenden Metallschicht, wobei dieser Kontakt durch die Kapselung, und der zweite Basenkontakt (B) durch die dritte Nichtleiterschicht geschützt ist,
i₃) Entfernung der Distanzstücke und der Kapselung des ersten Emitterkontakts (E),
i₄) Entfernung der besagten dritten Nichtleiterschicht und "Lift-off" der Maske und des Teils der sie bedeckenden Metallschicht.

7. Verfahren laut Anspruch 8, mit dem Merkmal, daß bei Schritt i₁ die dritte Nichtleiterschicht mit einer Ebnungsmethode erstellt wird, z.B. aus Fotoresist oder Polyamid.

8. Verfahren laut einem der Ansprüche 6 oder 7, mit dem Merkmal, daß bei Schritt i₂) die Entfernung des Metallschichtteils chemisch vorgenommen wird.

9. Verfahren laut einem der Ansprüche 1 bis 8, mit dem Merkmal, daß bei Schritt fₒ) die spezifische Größe h₁ gleich dem gewünschten Abstand zwischen dem Emitterkontakt und dem Basenkontakt vorgesehen ist.

10. Verfahren laut einem der Ansprüche 1 bis 9, mit dem Merkmal, daß die Halbleiterschichten zwischen der Basisschicht und der Emitterschicht einen Heteroübergang aufweisen.

11. Verfahren laut einem der Ansprüche 1 bis 10, mit dem Merkmal, daß für die Bildung der Kollektorkontakte (C) des Heteroübergang-Bipolartransistors die sogenannte dritte Kontaktelektrode zusätzlich folgendes enthält :
jₒ) Bildung einer Maske mit Öffnungen, die mit den für die Kollektorkontakte (C) vorgesehenen Bereichen übereinstimmen,
kₒ) Gravur der Halbleiterschichten in den Öffnungen bis zur Kollektorschicht,
lₒ) Aufbringung einer dritten Metallschicht zur Bildung der Kollektorkontakte,
mₒ) "Lift-off" der Maske und des unerwünschten Teils der dritten Metallschicht, der sie bedeckt.

## Claims

1. A method of manufacturing a semiconductor device of the bipolar heterojunction transistor (BHT) type, comprising the following steps for forming autoaligned emitter and base contacts:
a₀) stacking at least three semiconductor layers of alternating conductivity types on a substrate to form, respectively, the collector, base and emitter layers of the transistor;
b₀) deposition of a photoresist layer (8) on the surface of the upper emitter layer (5a; 5b), referred to as first semiconductor layer, and formation of an opening (B₀) in said photoresist layer (8), which opening delimits the area of a first electrode contact, characterized in that said first electrode contact is the emitter contact of the transistor, in that, in step b₀) the opening (B₀) is formed in the photoresist layer (8) by a method referred to as image reversal method, said opening having overhanging sides (F₁), i.e. a convex shape of which the thickening is directed towards said opening (B₀), and in that the method further comprises the following steps:
c₀) deposition of a first metal layer (9) on the surface of said photoresist layer (8) and directly on the surface of said first semiconductive emitter layer (5a; 5b) for forming said first emitter contact (E) which is delimited by the upper part of said opening (B₀), the height of said first emitter contact (E) being smaller than the thickness of the photoresist layer (8), and the upper parts of the sides (F₂) of said first emitter contact extend to a small distance (d) ≠ 0 from the overhanging sides F₁ of the opening (B₀), and an opening (A) being formed between the lower parts of said sides and the lower part of said overhanging sides (F₁),
d₀) deposition of a dielectric layer (10), referred to as first dielectric layer, having a thickness which is greater than said small distance (d), which dielectric layer covers the first metal layer without filling the opening (A),
e₀) removal (lift-off) of the photoresist layer, thereby entraining said first metal layer (9) and said first dielectric layer (10) around the first emitter contact (9), which remains covered by a part of the first dielectric layer (10) referred to as encapsulation.
f₀) deposition of a dielectric layer, referred to as second dielectric layer, having a uniform, specific thickness (h₁), and then uniformly etching away this second dielectric layer (12) over a height equal to the given thickness (h₁) so as to form spacers (12) having a lateral dimension equal to said specific thickness (h₁) around the first emitter contact (9),
g₀) etching of the first semiconductive emitter layer (5a, 5b), around the first emitter contact (E) (9) provided with the encapsulation (10) and spacers (12), the contact thus equipped serves as a first mask (11) for said etching operation, in which etching is continued until the subjacent semiconductive base layer (3) referred to as second semiconductor layer is reached, said etching operation including underetching under said spacers (12),
h₀) deposition of a second metal layer (16) for forming said second base contact (8) which is bounded on the one hand by said first mask (11) formed from the first emitter contact (E) provided with the encapsulation and spacers, and on the other hand by the edges of the opening of a second mask;
i₀) removal of the encapsulation (10), the spacers (12) and the second mask, thereby causing the portion of the metal layer (16) deposited on said encapsulation, on said spacers and on said second mask in the preceding step, to be removed too by a lift-off process.

2. A method as claimed in Claim 1, characterized in that during step b₀) the overhanging sides of the opening B₀ in the photoresist layer are formed with a substantially vertical upper portion F'₁ and a lower portion F"₁ which has a convexity of which the thickening is directed towards the opening B₀.

3. A method as claimed in Claim 2, characterized in that, in order to achieve that the sides of the opening Bo have a substantially vertical upper portion F'₁ and a lower portion F"₁ which has a convexity directed towards the opening B₀, the image reversal process is followed comprising at least the following steps:
- the upper surface of the first semiconductor layer is covered with a photoresist of the positive type which is reversible by treatments, in which the opening B₀ with overhanging sides is to be provided, and a first heat treatment of this photoresist is carried out,
- a mask for protecting the surface of the photoresist region destined finally to form the opening B₀ is realised;
- the photoresist is irradiated through a thickness e₁ smaller than its total thickness and approximately equal to the height desired for the portion F'₁ of the vertical sides of the opening B₀, by means of a first ultraviolet radiation having a first wavelength (λ₁);
- the said mask is removed and the photoresist is baked for curing it in the irradiated regions;
- the photoresist is completely irradiated throughout its thickness, the regions outside the region of the future opening B₀ having become a mask for the present operation as a result of the preceding operations, the irradiation taking place with ultraviolet light having a second wavelength which is larger than or equal to the first wavelength (λ₂ ≥ λ₁);
- the photoresist is developed in an agent which is capable of dissolving the irradiated regions which have not been baked at the end, i.e. the region of the opening B₀, which results in an opening having substantially vertical sides F'₁ in the portion which was irradiated through a small thickness and baked after irradiation, and underetched sides F"₁ in the portion which was irradiated throughout its thickness without final baking after irradiation.

4. A method as claimed in Claims 2 or 3, characterized in that during step c₀) the upper edges of the sides (F₂) of the first metal contact (E) extend to said small lateral distance d from the overhanging sides (F₁) of the opening (B₀) in the portion where the latter sides have their change in curvature between the vertical part and the convex part (F'₁ and F"₁, respectively).

5. A method as claimed in any one of the Claims 1 to 4, characterized in that during step f₀) the spacers are formed by deposition of a second dielectric layer of a material identical to that of the first dielectric layer.

6. A method as claimed in any one of Claims 1 to 5, characterized in that during step i₀) the removal of the undesirable elements comprises:
i₁) the deposition of a third dielectric layer of a different material from that of the encapsulation and the spacers, with a substantially planar upper surface, leaving the portion of the second metallic layer which covers the first encapsulated electrode contact E uncovered;
i₂) the removal of the portion of the second metallic layer which covers the first encapsulated electrode contact E, this first contact being protected by its encapsulation and the second electrode contact B being protected by the third dielectric layer;
i₃) the removal of the spacers and the encapsulation of the first emitter contact E;
i₄) the removal of the said third dielectric layer and the lift-off of the mask and of the portion of the metallic layer which covers it.

7. A method as claimed in Claim 6, characterized in that during step i₁) the third dielectric layer is realised by a planarizing method, for example, in photoresist or polyimide.

8. A method as claimed in the Claim 6 or 7, characterized in that during step i₂) the removal of the portion of the metal layer is effected by chemical means.

9. A method as claimed in any one of Claims 1 to 8, characterized in that during step f₀) the specific value h₁ is taken to be equal to the desired distance between the emitter and the base contacts.

10. A method as claimed in any one of Claims 1 to 9, characterized in that the semiconductor layers comprise a heterojunction between the base layer and the emitter layer.

11. A method as claimed in any one of Claims 1 to 10, characterized in that, for forming the collector contacts (C) of the bipolar heterojunction transistor, termed third electrode contact, said method comprises in addition:
j₀) the formation of a mask having openings coinciding with the regions destined for the collector contacts (C),
k₀) etching of the semiconductor layers in these openings down to the collector layer,
l₀) the deposition of a third metal layer for forming the collector contacts,
m₀) "lift-off" of the mask and of the undesirable portion of the third metal layer which covers it.
